# EUROPEAN PATENT APPLICATION

(11) **EP 4 664 373 A1**
(43) Date of publication of application: **17.12.2025**
(21) Application number: 23920302.9
(22) Date of filing: 07.02.2023
(51) Int. Cl.: G06Q 10/30, G06Q 30/02

(54) **BATTERY SECONDARY USE ASSISTANCE DEVICE, IN-VEHICLE TERMINAL, USER TERMINAL, BATTERY SECONDARY USE ASSISTANCE SYSTEM, AND BATTERY SECONDARY USE ASSISTANCE METHOD**

(71) Applicant: Nissan Motor Co., Ltd., Kanagawa 221-0023 (JP)
(72) Inventor: SUGINAKA, Yusuke, Atsugi-shi, Kanagawa 243-0123 (JP); TANAKA, Daisuke, Atsugi-shi, Kanagawa 243-0123 (JP); BIN ABD RAHMAN, Mohammad Alif Aimullah, Atsugi-shi, Kanagawa 243-0123 (JP); HIRATA, Norihiko, Atsugi-shi, Kanagawa 243-0123 (JP)
(74) Representative: Hoefer & Partner Patentanwälte mbB
(86) International application number: PCT/JP2023/003968
(87) International publication number: WO 2024/166203

(57) **Abstract**

Provided is a battery secondary use assistance device. The battery secondary use assistance device obtains a use tendency information on the vehicle or the secondary battery. The battery secondary use assistance device includes a degradation history data generation unit that generates degradation history data based on the use tendency information, a battery state data generation unit that calculates a predicted battery state quantity based on the degradation history data and generates predicted battery state data, a user-provided data unit that generates user-provided data based on the predicted battery state data, and a data output unit that outputs the user-provided data to a user terminal and/or an in-vehicle terminal.

## Description

### TECHNICAL FIELD

The present invention relates to a battery secondary use assistance device, an in-vehicle terminal, a user terminal, a battery secondary use assistance system, and a battery secondary use assistance method.

### BACKGROUND ART

In recent years, a system has been established for selling a mounted secondary battery (battery) and providing the secondary battery to a designated reuse destination (secondary use destination) when a user of a vehicle such as an electric vehicle (EV) or a hybrid electric vehicle (HEV) disposes of the vehicle. In this system, the secondary use destination (for stationary power supply, mobile power supply, or the like) is determined depending on a state of the secondary battery at the timing of ending use (primary use) as an in-vehicle battery.

As described above, by providing the in-vehicle secondary battery that has completed the primary use to the designated secondary use destination, it is possible to reduce a quantity of secondary battery waste itself while satisfying a need for a storage power supply in secondary use applications. Therefore, it is desired to widely spread the system that supplies the in-vehicle secondary battery to a secondary use destination.

As one means for spreading the system, it is desired to prompt a vehicle user who is a primary user to provide (sell) a secondary battery to a secondary use destination. From this perspective, there is known a technique of estimating a degradation state of a secondary battery directly related to a battery value when the secondary battery is provided to a secondary use destination.

WO2021/193006A1 discloses a battery reuse assistance system that estimates a degradation state of a battery at a scheduled sale time acquired from a user based on a degradation state of the battery during use of a vehicle (during primary use), determines a plurality of mountable product types (secondary use destinations) from the estimated degradation state, calculates a transaction price (predicted sale price) of the battery for each product type, and notifies the user of the transaction price.

### SUMMARY OF INVENTION

However, in WO2021/193006A1, the degradation state of the battery at the scheduled sale time is calculated based on a predetermined uniform degradation line. Therefore, the estimated value of a battery degradation state may deviate from an actual value, and reliability of the predicted sale price finally notified to the user may not be secured.

In particular, it is also assumed that a period from a timing of notifying the user using the vehicle of the predicted sale price to a time when the battery is removed from the vehicle and provided to the secondary use destination spans about several years to a decade. Therefore, the estimated value of the battery degradation state calculated based on the uniform degradation line deviates significantly from the actual value, and there is a concern that the reliability of the predicted sale price notified to the user may be significantly reduced. As a result, an effect of prompting the user to provide the secondary battery to the secondary use destination may be reduced.

Therefore, an object of the present invention is to more effectively prompt a user to provide a secondary battery to a secondary use destination, and to prompt the user to further provide the secondary battery for secondary use, thereby reducing a quantity of battery waste.

According to an aspect of the present invention, there is provided a battery secondary use assistance device that assists a user of a vehicle equipped with a secondary battery in providing the secondary battery for secondary use. The battery secondary use assistance device includes: a degradation history data generation unit configured to generate degradation history data indicating degradation progression of the secondary battery from a predetermined reference time to a current time based on use tendency information on the vehicle or the secondary battery; a battery state data generation unit configured to calculate a predicted battery state quantity indicating a state of the secondary battery at a predetermined primary use end time or a predetermined secondary use start time based on the degradation history data and generate predicted battery state data including the predicted battery state quantity; a user-provided data generation unit configured to generate user-provided data based on the predicted battery state data; and a data output unit configured to output the user-provided data to a user terminal to be operated by the user and/or an in-vehicle terminal mounted on the vehicle.

### BRIEF DESCRIPTION OF DRAWINGS

[FIG. 1] FIG. 1 is a block diagram illustrating a main configuration of a battery secondary use assistance system common to respective embodiments.
[FIG. 2] FIG. 2 is a block diagram illustrating details of configurations of a battery secondary use assistance system according to a first embodiment.
[FIG. 3] FIG. 3 is a flowchart for explaining details of processing performed by a battery secondary use assistance device of the first embodiment.
[FIG. 4A] FIG. 4A is a flowchart for explaining details of predicted battery state data generation according to the first embodiment.
[FIG. 4B] FIG. 4B illustrates an example of a calculation result of a predicted battery state quantity.
[FIG. 4C] FIG. 4C illustrates an example of a predicted degradation profile corresponding to each user.
[FIG. 5] FIG. 5 is a flowchart for explaining details of user-provided data generation according to the first embodiment.
[FIG. 6] FIG. 6 is a block diagram illustrating details of configurations of a battery secondary use assistance system according to a second embodiment.
[FIG. 7] FIG. 7 is a flowchart for explaining details of processing performed by a battery secondary use assistance device of the second embodiment.
[FIG. 8] FIG. 8 is a flowchart for explaining details of predicted battery state data generation according to the second embodiment.
[FIG. 9] FIG. 9 is a flowchart for explaining details of user-provided data generation according to the second embodiment.
[FIG. 10] FIG. 10 illustrates an example of a display mode of user-provided data according to the second embodiment.
[FIG. 11] FIG. 11 illustrates an example of a display mode of user-provided data according to a third embodiment.
[FIG. 12] FIG. 12 illustrates an example of calculation of a predicted sale price according to a fourth embodiment.
[FIG. 13] FIG. 13 illustrates an example of a display mode of user-provided data according to the fourth embodiment.

### DESCRIPTION OF EMBODIMENTS

Hereinafter, embodiments of the present invention will be described with reference to the drawings.

### [First Embodiment]

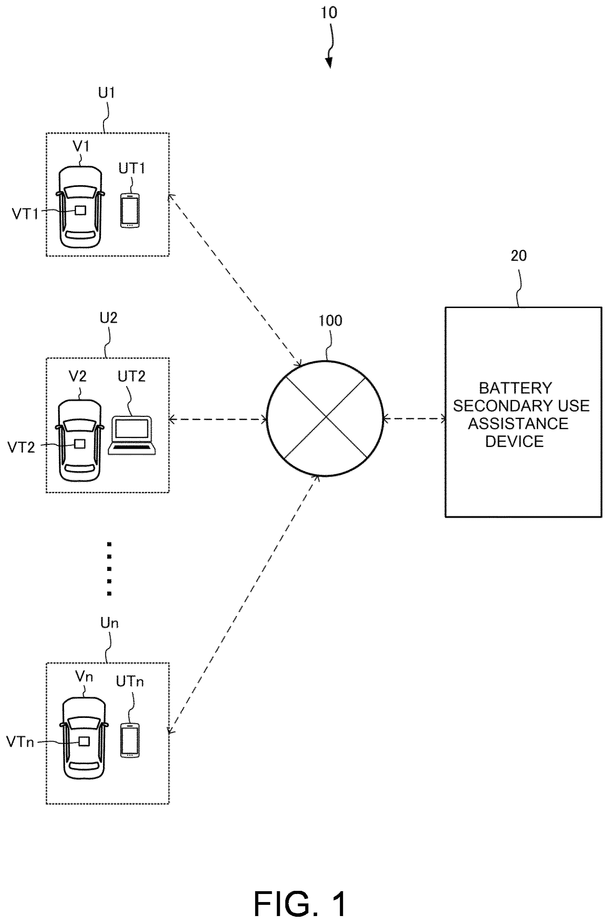

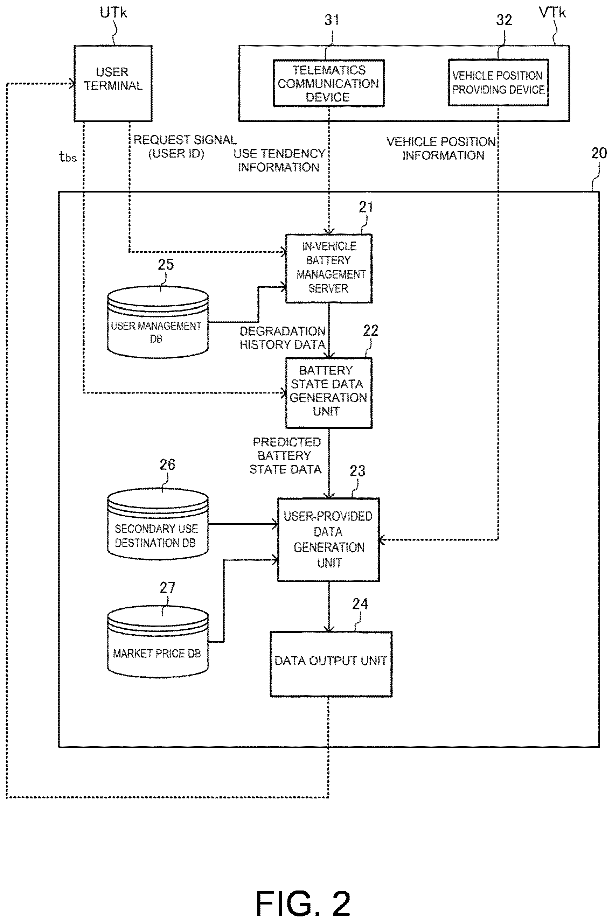

FIG. 1 illustrates a configuration of a battery secondary use assistance system 10 according to the present embodiment. FIG. 2 is a block diagram illustrating details of configurations of the battery secondary use assistance system 10. The battery secondary use assistance system 10 of the present embodiment is configured as a system for generating information for prompting users U (U1, U2, ..., Un) of vehicles V (V1, V2, ..., Vn in FIG. 1) each equipped with an in-vehicle secondary battery to provide the secondary battery for secondary use (reuse) and providing the information to the respective users U. As the vehicles V of the present embodiment, an electric vehicle, a hybrid vehicle, or the like on which an in-vehicle secondary battery is mounted is assumed.

In particular, the battery secondary use assistance system 10 mainly includes a battery secondary use assistance device 20, user terminals UT (UT1, UT2, ..., UTn) provided for operation of the users U, and in-vehicle terminals VT (VT1, VT2, ..., VTn) mounted on the vehicles V.

The battery secondary use assistance device 20 is connected to the user terminals T and the in-vehicle terminals VT via a predetermined network 100 so as to be able to communicate with each other. The network 100 includes various hardware and communication protocols for enabling communication among the battery secondary use assistance device 20, the user terminals UT, and the in-vehicle terminals VT. In particular, a communication function between the user terminals UT and the battery secondary use assistance device 20 is implemented by various communication protocols such as TCP/IP for performing wide area network communication. Further, a communication function between the in-vehicle terminals VT and the battery secondary use assistance device 20 is implemented by various communication protocols for realizing so-called telematics (mobile communication system).

Hereinafter, details of components of the battery secondary use assistance system 10 will be described. Hereinafter, in order to clarify that the description represents any one of the users U (U1, U2, ..., Un), a symbol "k" (where k is any integer from 1 to n) is appropriately used. The same applies to the user terminals UT (UT1, UT2, ..., UTn), the vehicles V (V1, V2, ..., Vn), and the in-vehicle terminals VT (VT1, VT2, ..., VTn).

### <Battery Secondary Use Assistance Device 20>

The battery secondary use assistance device 20 includes various calculation/control devices, a storage device, and an input/output device, and is configured by a computer in which a program for executing desired calculation/control processing is stored in the storage device. The battery secondary use assistance device 20 receives a request from a user terminal UTk, and acquires use tendency information and vehicle position information of a vehicle Vk or a secondary battery used by a user Uk from an in-vehicle terminal VTk. The battery secondary use assistance device 20 generates predicted battery state data of the secondary battery corresponding to the user Uk based on the information. Further, the battery secondary use assistance device 20 generates user-provided data on the secondary battery based on the predicted battery state data and outputs the user-provided data to the user terminal UTk.

More specifically, the battery secondary use assistance device 20 includes an in-vehicle battery management server 21, a battery state data generation unit 22, a user-provided data generation unit 23, a data output unit 24, a user management DB 25, a secondary use destination DB 26, and a market price DB 27.

The in-vehicle battery management server 21 is a server for managing a secondary battery mounted on the vehicle Vk. In particular, when the in-vehicle battery management server 21 of the present embodiment receives a request signal for requesting presentation of user-provided data from the user terminal UTk, the in-vehicle battery management server 21 specifies the vehicle Vk and the in-vehicle terminal VTk associated with a user ID included in the request signal with reference to the user management DB 25. Further, the in-vehicle battery management server 21 acquires the use tendency information of the vehicle Vk or the secondary battery mounted on the vehicle Vk by communicating with the specified in-vehicle terminal VTk.

Here, the use tendency information of the vehicle Vk includes, for example, parameters suggesting a use tendency of the vehicle Vk that may affect the degradation progression of the secondary battery up to a current time, such as a travel frequency, a travel distance, and/or a stopping time or start switch-off time of the vehicle Vk. In addition, the use tendency information of the secondary battery includes parameters suggesting the use tendency of the secondary battery that may affect the degradation progression of the secondary battery up to the current time, such as the number of times of charging and discharging, an average temperature, and/or a duration maintained in a non-charging/discharging state.

The in-vehicle battery management server 21 generates, based on the acquired use tendency information, degradation history data indicating transition of a degradation state of the secondary battery from a predetermined reference time t₀ (in particular, a primary use start time t₁ₛ such as a product shipment date or a vehicle purchase date) to a current time. In particular, the degradation history data includes a change history of a parameter that suggests a transition of a degradation state (health state) up to the current time corresponding to a manner in which the user Uk uses the vehicle Vk. For example, the in-vehicle battery management server 21 calculates a change history of a state of health (SOH) of the secondary battery as the transition of the degradation state. Here, SOH is defined as a ratio (capacity retention ratio) of a current battery capacity (full charge capacity) to an initial battery capacity (full charge capacity) (when new). A configuration of calculating a change history of a parameter (internal resistance or the like) suggesting a degradation state other than SOH may be adopted. The in-vehicle battery management server 21 transmits the generated degradation history data to the battery state data generation unit 22 in association with the user ID and a desired trading time t_{bs} included in the request signal.

The battery state data generation unit 22 calculates, based on the desired trading time t_{bs} and the degradation history data, a predicted battery state quantity Aₖ indicating the state of the secondary battery at a predetermined primary use end time t₁ₑ or a predetermined secondary use start time t₂ₑ, and generates predicted battery state data including the predicted battery state quantity. Here, the predicted battery state quantity Aₖ is calculated as a state quantity estimated value of the secondary battery that can affect a selectable secondary use destination Su or a sale price at the secondary use start time t₂ₑ. Examples of the predicted battery state quantity Aₖ include the SOH and an average internal resistance of the secondary battery at the secondary use start time t₂ₑ. Further, the battery state data generation unit 22 generates predicted battery state data including the predicted battery state quantity Aₖ. The battery state data generation unit 22 transmits the generated predicted battery state data to the user-provided data generation unit 23 in association with the user ID and the desired trading time t_{bs}. Details of the processing in the battery state data generation unit 22 will be described later.

The user-provided data generation unit 23 calculates a predicted sale price sp of the secondary battery at the secondary use start time t₂ₑ based on the vehicle position information and the predicted battery state data acquired from the in-vehicle terminal VTk. Here, the predicted sale price sp means a predicted value of a sale price (residual price) of the secondary battery at the set secondary use start time t₂ₑ. Further, the user-provided data generation unit 23 generates user-provided data including the calculated predicted sale price sp, and transmits the user-provided data to the data output unit 24 in association with the user ID. Details of the processing in the user-provided data generation unit 23 will be described later.

The data output unit 24 outputs the user-provided data to the user terminal UTk associated with the user ID. The data output unit 24 may have a so-called Software as a Service (SaaS) function of displaying the predicted sale price sp and other necessary information contained in the user-provided data on a display screen of the user terminal UTk in a desired display mode.

The user management DB 25 is a database in which a user ID uniquely assigned to the user terminal UTk and a vehicle ID uniquely assigned to the vehicle Vk used by the user Uk and the in-vehicle terminal VTk are stored in association with each other.

The secondary use destination DB 26 is a database that stores information on the secondary use destination Su (provision location and secondary use application of the secondary battery) corresponding to the battery state. The provision location of the secondary battery means a location where the secondary battery is provided (transported) when the secondary use is started. In addition, the secondary use application means a specific usage (for a stationary power supply, a mobile power supply, a vehicular mounted application, or the like) of the secondary battery during secondary use.

The market price DB 27 is a database that stores a battery transaction price corresponding to the battery state, the secondary use destination Su, and a sale time. In particular, the battery transaction price stored in the market price DB 27 is determined by correcting a basic transaction price determined from the battery state and the secondary use application based on market price fluctuation such as an increase or decrease in demand corresponding to the sale time.

### <User Terminal>

The user terminal UTk is a terminal to be operated by the user Uk, and includes a mobile terminal such as a smartphone or a tablet terminal, or a personal computer such as a notebook computer (laptop computer) or a desktop computer.

In particular, when the user terminal UTk detects an input operation for requesting provision of user-provided data by the user Uk, the user terminal UTk generates a request signal including a predetermined user ID and the desired trading time t_{bs} designated by the user Uk, and transmits the request signal to the battery secondary use assistance device 20. In addition, the user terminal UTk includes a display device (display screen) for displaying the predicted sale price sp and other necessary information included in the user provision received from the battery secondary use assistance device 20 in a predetermined mode according to a program stored in an own storage area or by the processing of the battery secondary use assistance device 20.

### <In-Vehicle Terminal>

The in-vehicle terminal VTk is an in-vehicle computer that is to be mounted on the vehicle Vk and provides necessary information to the battery secondary use assistance device 20. In particular, the in-vehicle terminal VTk of the present embodiment includes a telematics communication device 31 and a vehicle position providing device 32.

The telematics communication device 31 is a device for implementing communication between the vehicle Vk and another vehicle V, and telematics communication between the vehicle Vk and the battery secondary use assistance device 20. In particular, in response to a command from the in-vehicle battery management server 21, the telematics communication device 31 outputs, to the battery secondary use assistance device 20, values detected by sensors (not illustrated) mounted on the vehicle Vk and/or a data group obtained by communication with another vehicle V as use tendency information of the vehicle Vk.

The vehicle position providing device 32 is implemented by a function (such as a GPS system) for detecting a position of the vehicle Vk and various hardware and software for transmitting the detected position as vehicle position information to the battery secondary use assistance device 20. Hereinafter, specific processing executed by the battery secondary use assistance device 20 will be described in more detail.

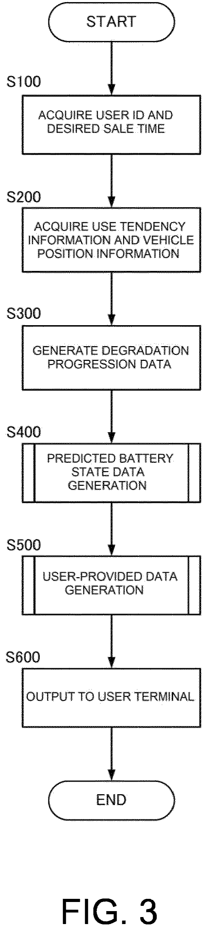

FIG. 3 is a flowchart illustrating details of processing performed by the battery secondary use assistance device 20.

In step S100, the in-vehicle battery management server 21 acquires the user ID from the user terminal UTk. The battery state data generation unit 22 acquires the desired trading time t_{bs} from the user terminal UTk.

In step S200, the in-vehicle battery management server 21 acquires the use tendency information of the vehicle Vk from the in-vehicle terminal VTk. The user-provided data generation unit 23 acquires the vehicle position information from the in-vehicle terminal VTk.

In step S300, the in-vehicle battery management server 21 generates degradation history data based on the acquired use tendency information. In particular, the degradation history data of the present embodiment includes cycle degradation history data indicating a transition of cycle degradation of the secondary battery from the reference time to to the current time, and storage degradation history data indicating a transition of storage degradation of the secondary battery from the reference time t₀ to the current time. The in-vehicle battery management server 21 generates the cycle degradation history data with reference to the travel frequency (travel time or the like) of the vehicle Vk contained in the use tendency information. The in-vehicle battery management server 21 generates the storage degradation history data with reference to a stopping frequency (stopping time or the like) of the vehicle Vk contained in the use tendency information.

In step S400, the battery state data generation unit 22 generates predicted battery state data based on the desired trading time t_{bs} and the degradation history data.

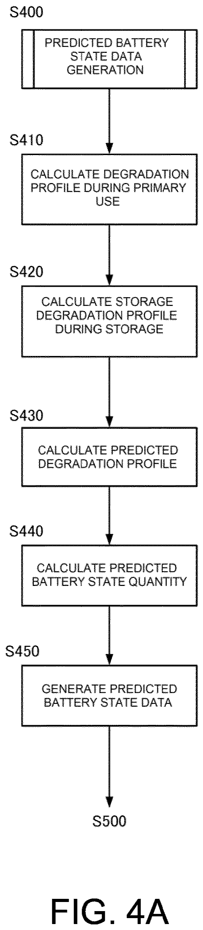

FIG. 4A is a flowchart for explaining details of predicted battery state data generation according to the present embodiment.

First, the battery state data generation unit 22 calculates a degradation profile during primary use P_{TO1k}(t) based on the desired trading time t_{bs} and the degradation history data (S410). Here, the degradation profile during primary use P_{TO1k}(t) means a function indicating the degradation transition of the secondary battery corresponding to the usage mode of the vehicle Vk by the user Uk from the reference time t₀ to the primary use end time t₁ₑ through the present. The primary use end time t₁ₑ means a timing at which the use of the vehicle Vk (secondary battery) by the user Uk ends. In particular, the primary use end time t₁ₑ is determined as a time point when the secondary battery is removed from the vehicle Vk after the user Uk has completed a procedure such as a sale contract of the vehicle Vk (secondary battery). In the following, for simplification of description, it is treated that the desired trading time t_{bs} and the primary use end time t₁ₑ coincide with each other, but in consideration of a period from completion of a procedure such as a sale contract to a time point when the secondary battery is actually removed from the vehicle Vk, the period may be added to the desired trading time t_{bs} to determine the primary use end time t₁ₑ.

More specifically, the battery state data generation unit 22 calculates the cycle degradation profile P_{C1k}(t) indicating the transition of the cycle degradation from the reference time to to the primary use end time t₁ₑ based on the cycle degradation history data contained in the degradation history data. The cycle degradation profile P_{C1k}(t) is a function indicating the transition of the cycle degradation of the secondary battery from the reference time t₀ to the primary use end time t₁ₑ. In particular, assuming that the cycle degradation transition from the reference time t₀ to the current time defined by the cycle degradation history data is maintained even thereafter, the battery state data generation unit 22 acquires a function obtained by extending the cycle degradation transition to the primary use end time t₁ₑ as the cycle degradation profile P_{C1k}(t).

In addition, the battery state data generation unit 22 calculates a storage degradation profile P_{S1k}(t) indicating a transition of storage degradation from the reference time t₀ to the primary use end time t₁ₑ based on the storage degradation history data contained in the degradation history data. The storage degradation profile P_{S1k}(t) is a function indicating a transition of storage degradation of the secondary battery from the reference time t₀ to the primary use end time t₁ₑ. In particular, assuming that the storage degradation transition from the reference time t₀ to the current time defined by the storage degradation history data is maintained even thereafter, the battery state data generation unit 22 acquires a function obtained by extending the storage degradation transition to the primary use end time t₁ₑ as the storage degradation profile P_{S1k}(t).

Further, the battery state data generation unit 22 integrates the cycle degradation profile P_{C1k}(t) and the storage degradation profile P_{S1k}(t) to calculate the degradation profile during primary use P_{TO1k}(t). The degradation profile during primary use P_{TO1k}(t) is a function indicating a transition of total degradation (cycle degradation + storage degradation) from the reference time to to the primary use end time t₁ₑ.

Next, the battery state data generation unit 22 calculates a degradation profile during storage P_{S2k}(t) (S420). Here, the degradation profile during storage P_{S2k}(t) is a function indicating the transition of the storage degradation of the secondary battery in a storage period [t₁ₑ, t₂ₑ] from the primary use end time t₁ₑ to the secondary use start time t₂ₑ. The secondary use start time t₂ₑ means a date or a time when the secondary battery removed from the vehicle Vk after the primary use is actually provided to the secondary use destination Su. Further, the storage period [t₁ₑ, t₂ₑ] means a period during which the secondary battery is stored in a predetermined place from the primary use end time t₁ₑ to the secondary use start time t₂ₑ.

More specifically, the battery state data generation unit 22 calculates the degradation profile during storage P_{S2k}(t) based on a length of the scheduled storage period [t₁ₑ, t₂ₑ], a parameter (storage temperature, humidity, or the like) suggesting an environment in the scheduled storage place, and the like.

Further, the battery state data generation unit 22 acquires a predicted degradation profile P_{Uk}(t) indicating a degradation transition unique to the user Uk from the reference time t₀ to the secondary use start time t₂ₑ through the primary use end time t₁ₑ by integrating the degradation profile during primary use P_{TO1k}(t) and the degradation profile during storage P_{S2k}(t) (S430).

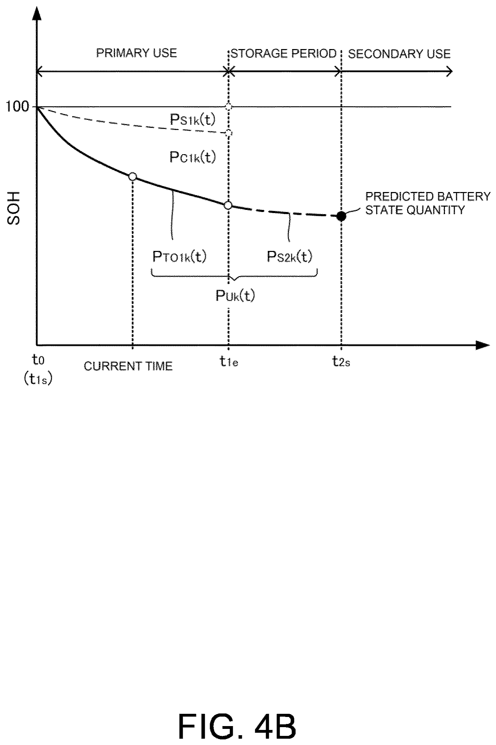

FIG. 4B illustrates an example of the predicted degradation profile P_{Uk}(t). As illustrated in the figure, according to the above calculation, it is possible to determine the predicted degradation profile P_{Uk}(t) indicating the transition of the degradation state of the secondary battery from the predetermined reference time to to the secondary use start time t₂ₑ through the present and the primary use time.

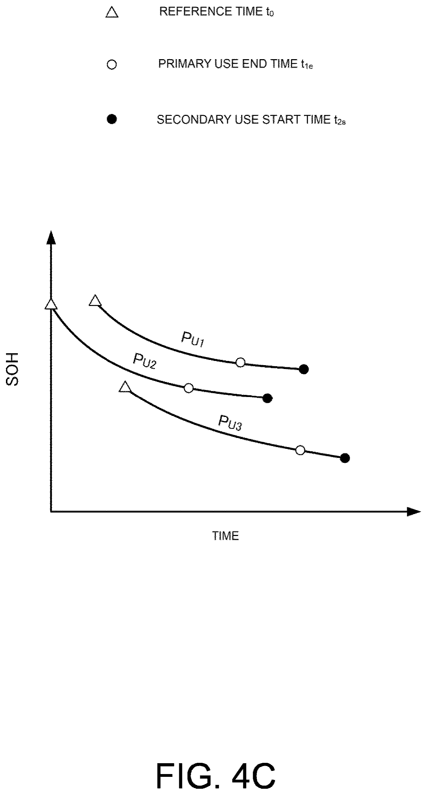

FIG. 4C illustrates an example of predicted degradation profiles P_{U1}, P_{U2}, and P_{U3} determined respectively for different users U1, U2, and U3. As illustrated in the figure, by executing the above calculation based on various inputs (use tendency information and the like) determined for each of the users U1, U2, and U3 (each user ID), it is possible to acquire the predicted degradation profile P_{U1}, P_{U2}, and P_{U3} each having a unique shape for respective users U1, U2, and U3.

In the examples illustrated in FIGS. 4B and 4C, the predicted degradation profile P_{Uk}(t) in a case where the capacity retention ratio (SOH) is assumed as a state quantity of the secondary battery is illustrated. Further, the predicted degradation profile P_{Uk}(t) may be calculated as a profile of any parameter (for example, internal resistance) that can suggest a degradation state other than SOH.

Returning to FIG. 4A, the battery state data generation unit 22 calculates the state quantity (predicted battery state quantity Aₖ) of the secondary battery at the secondary use start time t₂ₑ with reference to the predicted degradation profile P_{Uk}(t) (S440). The predicted battery state quantity Aₖ is an estimated value of the degradation state of the secondary battery at the secondary use start time t₂ₑ. In particular, the predicted battery state quantity Aₖ can be calculated as a value of the secondary use start time t₂ₑ on the predicted degradation profile P_{Uk}(t) which is a function of a time (period).

For example, when the predicted degradation profile P_{Uk}(t) is determined as a SOH profile of the secondary battery, the predicted battery state quantity Aₖ is calculated as the SOH of the secondary battery at the secondary use start time t₂ₑ (hereinafter, also referred to as "predicted SOH"). When the predicted degradation profile P_{Uk}(t) is determined as an internal resistance profile of the secondary battery, the predicted battery state quantity Aₖ is calculated as the internal resistance of the secondary battery at the secondary use start time t₂ₑ (hereinafter, also referred to as "predicted internal resistance").

Further, the battery state data generation unit 22 generates predicted battery state data including the calculated predicted battery state quantity Aₖ (S450). For example, the battery state data generation unit 22 generates a data group formed by combining the user ID, the predicted degradation profile P_{Uk}(t), and the predicted battery state quantity Aₖ as the predicted battery state data.

Returning to FIG. 3, in step S500, the user-provided data generation unit 23 calculates the predicted sale price sp of the secondary battery at the secondary use start time t₂ₑ based on the predicted battery state data, and generates the user-provided data including the predicted sale price sp.

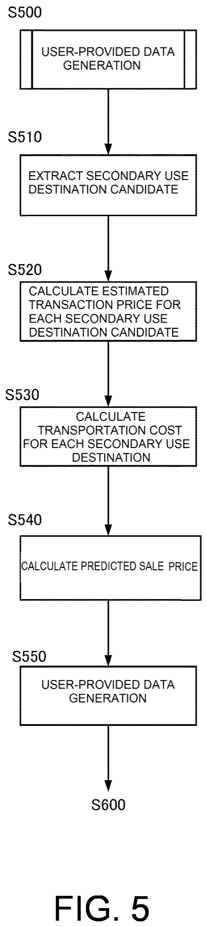

FIG. 5 is a flowchart for explaining details of user-provided data generation.

As illustrated in the figure, the user-provided data generation unit 23 extracts secondary use destination candidates Su_{[m]} (m is any natural number) with reference to the secondary use destination DB 26 based on the predicted battery state data (particularly, predicted battery state quantity Aₖ) (S510). For example, the user-provided data generation unit 23 compares the predicted battery state quantity Aₖ with a reference range of the battery state quantity determined for each of the secondary use destinations Su recorded in the secondary use destination DB 26, and extracts, as the secondary use destination candidates Su_{[m]}, one or more secondary use destinations Su in which the predicted battery state quantity Aₖ is included in the reference range. The reference range is preferably stored in advance in the secondary use destination DB 26 as a part of information on the secondary use destination Su.

Next, the user-provided data generation unit 23 refers to the market price DB 27 and calculates an estimated transaction price vt_{[m]} of the secondary battery corresponding to the predicted battery state quantity Aₖ at the secondary use start time t₂ₑ for each of the extracted secondary use destination candidates Su_{[m]} (S520). That is, the estimated transaction price vt_{[m]} is determined as an estimated value of the transaction price of the secondary battery at the secondary use start time t₂ₑ, considering the market price according to the predicted battery state quantity Aₖ.

Further, the user-provided data generation unit 23 calculates, for each of the secondary use destination candidates Su_{[m]}, a transportation cost tc_{[m]} required for transporting the secondary battery from a primary use location Pu to the secondary use destination candidate Su_{[m]} (S530).

More specifically, the user-provided data generation unit 23 first estimates the primary use location Pu of the secondary battery based on the vehicle position information acquired from the in-vehicle terminal VTk. For example, the user-provided data generation unit 23 generates an area of a predetermined range including a place where the vehicle Vk mainly exists based on the vehicle position information, and estimates a position of a facility in the area where the secondary battery can be removed from the vehicle Vk as the primary use location Pu with reference to a predetermined map database or the like. Further, the user-provided data generation unit 23 calculates the transportation costs tc_{[m]} for respective secondary use destination candidates Su_{[m]} based on information such as a distance between the primary use location Pu and a provision location in respective secondary use destination candidates Su_{[m]}.

Next, the user-provided data generation unit 23 calculates final predicted sale prices sp of the secondary battery from the estimated transaction prices vt_{[m]} and the transportation costs tc_{[m]} for respective secondary use destination candidates Su_{[m]} (S540). More specifically, the user-provided data generation unit 23 acquires, as the predicted sale price sp of the secondary battery, a maximum value among values (vt₍₁₎ - tc₍₁₎, vt₍₂₎ - tc₍₂₎, ...) obtained by subtracting the transportation costs tc_{[m]} respectively from the estimated transaction prices vt_{[m]}. The user-provided data generation unit 23 generates user-provided data including the obtained predicted sale price sp (S550).

Returning to FIG. 3, in step S600, the data output unit 24 outputs (transmits) the generated user-provided data to the user terminal UTk or the in-vehicle terminal VTk.

Further, the user terminal UTk or the in-vehicle terminal VTk displays the user-provided data in a predetermined mode on a display device (display screen) included in the user terminal UTk or the in-vehicle terminal VTk.

The functions and effects of the configuration of the battery secondary use assistance device 20 according to the present embodiment described above will be described.

According to the present embodiment, the battery secondary use assistance device 20 that assists the user Uk of the vehicle Vk equipped with the secondary battery in providing the secondary battery for secondary use is provided. The battery secondary use assistance device 20 includes a degradation history data generation unit (in-vehicle battery management server 21) that generates degradation history data indicating degradation progression of the secondary battery from the predetermined reference time to to the current time based on use tendency information on the vehicle Vk or the secondary battery, the battery state data generation unit 22 that calculates the predicted battery state quantity Aₖ indicating a state of the secondary battery at the predetermined secondary use start time t₂ₑ based on the degradation history data and generates the predicted battery state data including the predicted battery state quantity Aₖ, the user-provided data generation unit 23 that generates the user-provided data based on the predicted battery state data, and the data output unit 24 that outputs the user-provided data to the user terminal UTk to be operated by the user Uk.

Accordingly, it is possible to implement logic for predicting a battery state when the secondary battery is provided to the secondary use destination Su, considering the usage mode of the vehicle Vk or secondary battery unique to the user Uk, and for providing information obtained from the predicted battery state to the user Uk. Therefore, the reliability of the information to be provided to the user Uk can be ensured, and the user Uk can be further prompted to provide the secondary battery to the secondary use destination Su. As a result, the supply of the secondary battery to the secondary use destination Su can be further activated, and a quantity of battery waste can be reduced.

In particular, the in-vehicle battery management server 21 generates cycle degradation history data indicating a transition of cycle degradation of the secondary battery from the reference time t₀ to the current time with reference to a travel frequency of the vehicle Vk contained in the use tendency information, and generates storage degradation history data indicating a transition of storage degradation of the secondary battery from the reference time t₀ to the current time with reference to a stopping frequency of the vehicle Vk contained in the use tendency information. The battery state data generation unit 22 generates the cycle degradation profile P_{C1k}(t) indicating the transition of the cycle degradation from the reference time to to the primary use end time t₁ₑ based on the cycle degradation history data, and generates the storage degradation profile P_{S1k}(t) indicating the transition of the storage degradation from the reference time to to the primary use end time t₁ₑ based on the storage degradation history data. Further, the battery state data generation unit 22 generates the degradation profile during primary use P_{TO1k}(t) indicating the total degradation transition of the secondary battery from the reference time to to the primary use end time t₁ₑ based on the cycle degradation profile P_{C1k}(t) and the storage degradation profile P_{S1k}(t), and calculates the predicted battery state quantity Aₖ based on the degradation profile during primary use P_{TO1k}(t).

Accordingly, a specific logic for acquiring the predicted battery state quantity Aₖ with higher reliability is implemented.

Further, the battery state data generation unit 22 calculates the degradation profile during storage P_{S2k}(t) indicating the transition of degradation in the storage period [t₁ₑ, t₂ₑ] from the primary use end time t₁ₑ to the secondary use start time t₂ₑ, and calculates the predicted battery state quantity Aₖ based on the degradation profile during primary use P_{TO1k}(t) and the degradation profile during storage P_{S2k}(t).

Accordingly, a specific logic is implemented for acquiring the predicted battery state quantity Aₖ with higher reliability, which considers not only the degradation progression during the primary use period of the secondary battery by the user Uk but also the degradation progression during the storage period [t₁ₑ, t₂ₑ] until the secondary battery is provided for secondary use.

In particular, the battery state data generation unit 22 determines the primary use end time t₁ₑ and the secondary use start time t₂ₑ based on the desired trading time t_{bs} of the user Uk acquired in advance.

Accordingly, it is possible to implement a specific logic for calculating the predicted battery state quantity Aₖ corresponding to the desired trading time t_{bs} unique to the user Uk.

Further, the user-provided data generation unit 23 calculates the predicted sale price sp of the secondary battery at the secondary use start time t₂ₑ based on the predicted battery state data, and generates the user-provided data including at least the predicted sale price sp.

Accordingly, a specific logic is implemented for calculating the predicted sale price sp of the secondary battery at a scheduled provision time for secondary use and providing (notifying) information including the predicted sale price sp to the user Uk.

Further, the battery secondary use assistance device 20 of the present embodiment further includes a secondary use destination database (secondary use destination DB 26) in which information on the secondary use destination Su is stored, and a market price database (market price DB 27) in which a general battery transaction price corresponding to a battery state and a sale time is stored.

In addition, the user-provided data generation unit 23 extracts a plurality of secondary use destination candidates Su_{[m]} from the predicted battery state data (particularly, predicted battery state quantity Aₖ) with reference to the secondary use destination DB 26, calculates, with reference to the market price DB 27, the estimated transaction prices vt_{[m]} of the secondary battery based on the predicted battery state data according to the extracted secondary use destination candidates Su_{[m]}, and calculates the predicted sale prices sp based on the estimated transaction prices vt_{[m]} (see FIG. 5).

Accordingly, a specific logic is implemented for determining the predicted sale price sp from the predicted battery state quantity Aₖ unique to the user Uk in consideration of a battery trading market price corresponding to the secondary use destination Su.

In particular, the user-provided data generation unit 23 estimates the primary use location Pu of the secondary battery from the position information (vehicle position information) of the vehicle Vk, calculates the transportation costs tc_{[m]} of the secondary battery from the primary use location Pu to respective secondary use destination candidates Su_{[m]} with reference to the secondary use destination DB 26, and determines the predicted sale prices sp from a value obtained by subtracting the transportation costs tc_{[m]} from the estimated transaction prices vt_{[m]}.

Accordingly, a specific logic is implemented for determining the predicted sale price sp from the predicted battery state quantity Aₖ unique to the user Uk in consideration of the trading market price and the transportation cost tc_{[m]} corresponding to the secondary use destination Su.

### [Second Embodiment]

Hereinafter, a second embodiment will be described. Note that the same elements as those in the first embodiment are denoted by the same reference numerals, and the description thereof will be omitted.

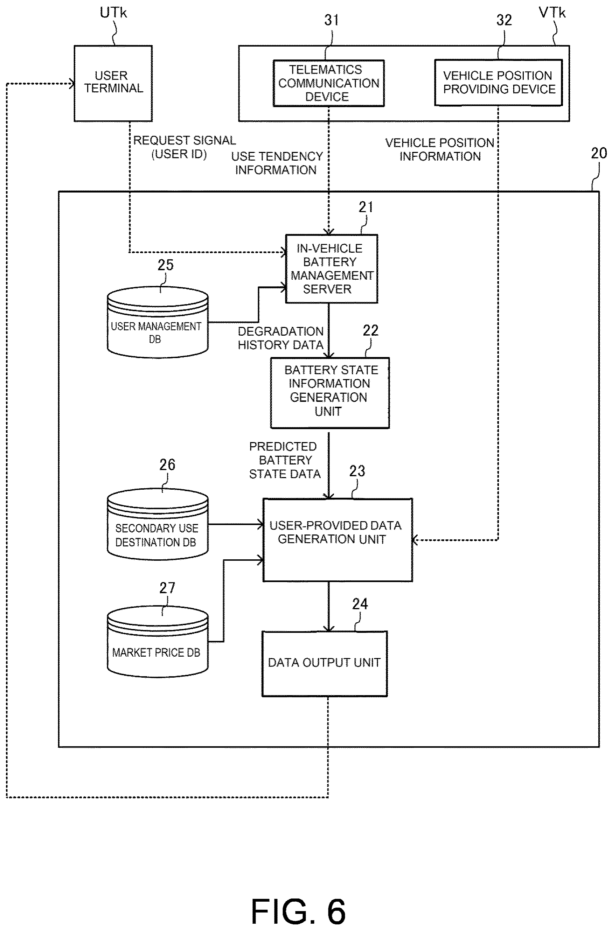

FIG. 6 is a block diagram illustrating details of configurations of the battery secondary use assistance system 10 of the present embodiment. As illustrated in FIG. 6, in the battery secondary use assistance system 10 of the present embodiment, only a user ID is included in a request signal transmitted by the user terminal UTk (the desired trading time t_{bs} is not included).

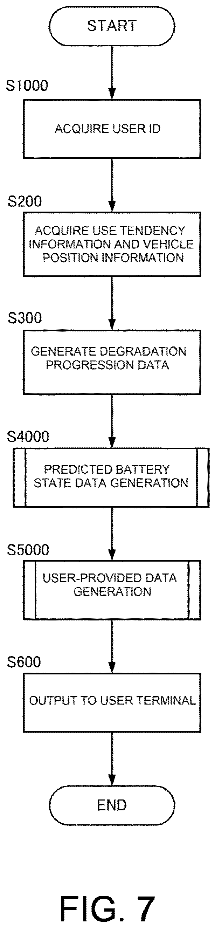

FIG. 7 is a flowchart illustrating details of processing performed by the battery secondary use assistance device 20. As illustrated in the figure, in the processing of the battery secondary use assistance device 20 of the present embodiment, only the user ID from the user terminal UT is acquired, and the desired trading time t_{bs} is not acquired (S1000). In the present embodiment, processing contents in the predicted battery state data generation (S4000) and the user-provided data generation (S5000) are different from those in the first embodiment.

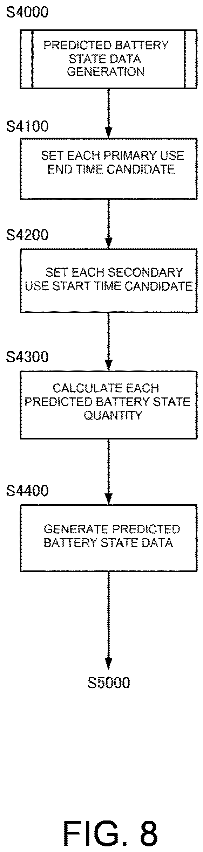

FIG. 8 is a flowchart illustrating details of the calculation of the predicted battery state quantity Aₖ according to the present embodiment.

First, the battery state data generation unit 22 sets a plurality of primary use end time candidates t_{1e[µ]} (µ is any natural number) (S4100). More specifically, the battery state data generation unit 22 acquires a plurality of possible candidates at the time of trading in accordance with a predetermined algorithm from information on a desire of the user Uk and the number of years of use of the vehicle Vk acquired in advance, and sets the candidates as the primary use end time candidates t_{1e[µ]}. Further, the battery state data generation unit 22 determines secondary use start time candidates t_{2e[µ]} respectively corresponding to the set primary use end time candidates t_{1e[µ]} (S4200).

The battery state data generation unit 22 calculates a predicted battery state quantity A_{k[µ]} based on the degradation history data of the secondary battery for each of the secondary use start time candidates t_{2e[µ]} (S4300). An arithmetic logic of the predicted battery state quantity A_{k[µ]} is the same as the calculation of the predicted battery state quantity Aₖ (S410 to S440) described in the first embodiment. Further, the battery state data generation unit 22 generates predicted battery state data including combinations ({A_{k[1]}, t_{1e[1]}}, {A_{k[2]}, t_{1e[2]}}, ...) of predicted battery state quantities A_{k[µ]} and the respective primary use end time candidates t_{1e[µ]} (S4400).

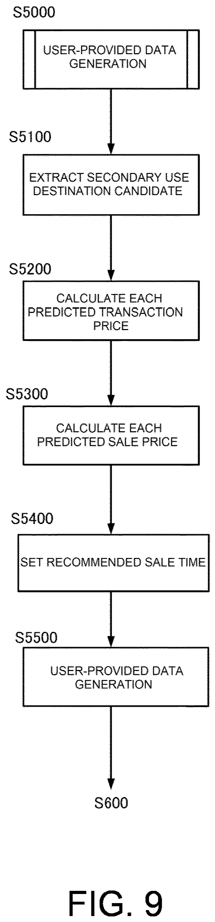

FIG. 9 is a flowchart illustrating details of user-provided data generation (S5000) according to the present embodiment.

As illustrated in the figure, the user-provided data generation unit 23 refers to the secondary use destination DB 26 to extract a secondary use destination candidate Su_{[µ]} based on the predicted battery state data (S5100). More specifically, for respective predicted battery state quantities A_{k[µ]} contained in the predicted battery state data, the user-provided data generation unit 23 extracts one secondary use destination Su capable of providing the secondary battery as the secondary use destination candidate Su_{[µ]}.

Next, the user-provided data generation unit 23 refers to the market price DB 27 to calculate estimated transaction prices vt_{[µ]} of the secondary battery for combinations of the predicted battery state quantities A_{k[µ]} and the respective secondary use destination candidates Su_{[µ]} (S5200). An arithmetic logic of each of the estimated transaction prices vt_{[µ]} is the same as an arithmetic logic (S520) in the first embodiment.

In addition, the user-provided data generation unit 23 acquires transportation costs tc_{[µ]} respectively corresponding to the estimated transaction prices vt_{[µ]}, and calculates predicted sale prices sp_{[µ]} from the estimated transaction prices vt_{[µ]} and the transportation costs tc_{[µ]} (S5300). Note that specific calculation contents are the same as the calculation of the predicted sale prices sp (S530, S540) in the first embodiment.

Further, the user-provided data generation unit 23 stores one primary use end time candidate t_{1e[M]} associated with a maximum sale price sp_{[M]} among the calculated predicted sale prices sp_{[µ]} in a predetermined storage area as a recommended sale time tᵣₑ (S5400).

The user-provided data generation unit 23 generates user-provided data including the recommended sale time tᵣₑ (S5500). In particular, the user-provided data generation unit 23 of the present embodiment generates user-provided data including the recommended sale time tᵣₑ and the maximum sale price sp_{[M]} associated therewith, and the primary use end time candidates t_{1e[µ]} other than the recommended sale time tᵣₑ and predicted sale prices sp_{[µ]} associated therewith.

Returning to FIG. 7, the data output unit 24 outputs the generated user-provided data to the user terminal UTk. In particular, in the user terminal UTk, the data output unit 24 of the present embodiment performs processing of displaying the recommended sale time tᵣₑ in a mode different from the mode of the other primary use end time candidates t_{1e[µ]}.

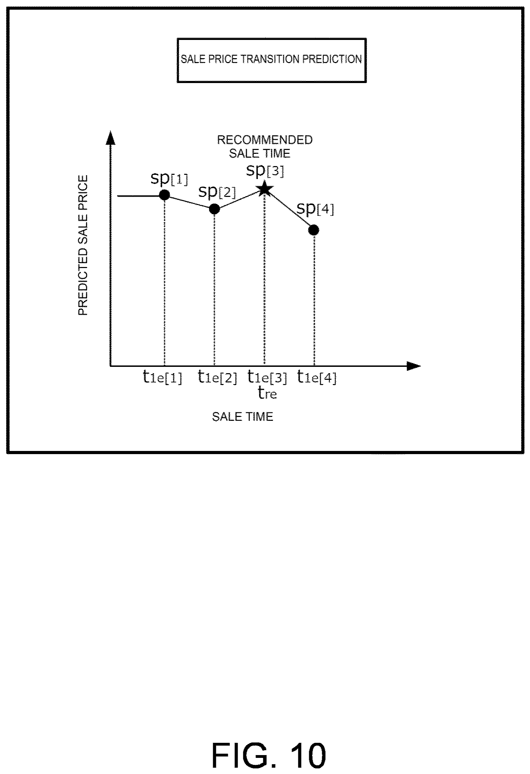

FIG. 10 illustrates an example of a display mode of the user-provided data on a display screen of the user terminal UTk. In the example of FIG. 10, a transition of the predicted sale prices sp for sale time candidates is displayed on the user terminal UTk. In particular, the transition of the predicted sale price sp fluctuates depending to the sale time due to the influence of the market price corresponding to the secondary use destination Su in addition to the degradation progression of the secondary battery over time. In the present embodiment, the recommended sale time tᵣₑ corresponding to the maximum sale price sp_{[M]} (sp_{[3]} in the figure) is distinguished from other sale time candidates (sp_{[1]}, sp_{[2]}, and sp_{[4]} in the figure) and is clearly illustrated. Therefore, the user Uk can recognize the timing when the secondary battery can be sold at a high cost. In the illustrated example, the predicted sale prices sp_{[µ]} at adjacent sale periods (annual) are displayed while being connected by a straight line, but the predicted sale prices sp_{[µ]} may be displayed only by a plot.

The functions and effects of the configuration of the battery secondary use assistance device 20 according to the present embodiment described above will be described.

In the present embodiment, the battery state data generation unit 22 calculates the predicted battery state quantities A_{k[µ]} for secondary use start time candidates t_{2e[µ]} respectively corresponding to a plurality of predetermined primary use end time candidates t_{1e[µ]}.

Accordingly, it is possible to implement a specific logic for determining the predicted battery state quantities A_{k[µ]} respectively corresponding to a plurality of sale time candidates assumed for the user Uk and generating the user-provided data based on the predicted battery state quantities A_{k[µ]}.

In particular, the battery state data generation unit 22 calculates the predicted battery state quantities A_{k[µ]} respectively corresponding to a plurality of predetermined primary use end time candidates t_{1e[µ]}, and generates the predicted battery state data including the combinations of the predicted battery state quantities A_{k[µ]} and the respective primary use end time candidates t_{1e[µ]}.

The user-provided data generation unit 23 extracts a plurality of secondary use destination candidates Su_{[µ]} based on the predicted battery state data with reference to the secondary use destination DB 26, and calculates the estimated transaction prices vt_{[µ]} of the secondary battery for the combinations of the predicted battery state quantities A_{k[µ]} and the secondary use destination candidates Su_{[µ]} with reference to the market price DB 27. Further, the user-provided data generation unit 23 calculates the predicted sale prices sp_{[µ]} respectively corresponding to the estimated transaction prices vt_{[µ]}, sets one primary use end time candidate t_{1e[µ]} associated with the maximum sale price sp_{[M]} among the predicted sale prices sp_{[µ]} as the recommended sale time tᵣₑ, and generates the user-provided data including the recommended sale time tᵣₑ (see FIG. 9).

Accordingly, it is possible to implement a specific logic for estimating, from the plurality of sale time candidates assumed for the user Uk, a sale timing when a sale price of the secondary battery becomes high while considering a market price fluctuation, and providing (notifying) the sale timing to the user Uk.

### [Third Embodiment]

Hereinafter, a third embodiment will be described. Note that the same elements as those in the first or second embodiment are denoted by the same reference numerals, and the description thereof will be omitted.

The battery secondary use assistance device 20 of the present embodiment further acquires the desired trading time t_{bs} of the user Uk based on the configuration of the second embodiment. In S4100 of FIG. 8, the battery state data generation unit 22 determines the primary use end time candidate t_{1e[µ]} based on the desired trading time t_{bs} of the user Uk. In particular, the battery state data generation unit 22 sets the primary use end time candidates t_{1e[µ]}, including the desired trading time t_{bs} of the user Uk and a timing in each unit period (for example, every year) included in predetermined previous and subsequent periods.

In S5500 of FIG. 9, the user-provided data generation unit 23 determines the recommended sale time tᵣₑ from the primary use end time candidates t_{1e[µ]}. Further, the user-provided data generation unit 23 generates user-provided data including the recommended sale time tᵣₑ and the maximum sale price sp_{[M]} associated therewith, the desired trading time t_{bs} of the user Uk and the predicted sale price sp_{[ths]} associated therewith, and the primary use end time candidates t_{1e[µ]} other than the recommended sale time tᵣₑ and the desired trading time t_{bs} and the predicted sale prices sp_{[µ]} associated therewith.

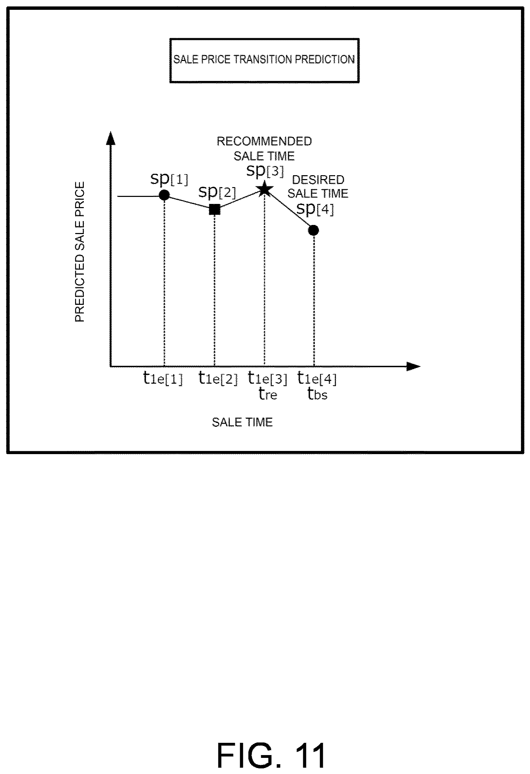

FIG. 11 illustrates an example of a display mode of the user-provided data according to the present embodiment. In the illustrated example, the predicted sale prices sp_{[µ]} corresponding to sale time candidates (primary use end time candidates t_{1e[µ]}) including the recommended sale time tᵣₑ and the desired trading time t_{bs} are graphically displayed. In particular, the recommended sale time tᵣₑ and the desired trading time t_{bs} are displayed separately from other sale timings. More specifically, the recommended sale time tᵣₑ is displayed in text, and the maximum sale price sp_{[M]} (sp_{[3]} in the figure) associated with the recommended sale time tᵣₑ is represented by a star-shaped plot. Further, the desired trading time t_{bs} is displayed in text, and the predicted sale price sp_{[ths]} (sp_{[4]} in the figure) at the desired trading time t_{bs} is represented by a circle plot. The predicted sale price sp_{[µ]} at another sale time (sp_{[1]} and sp_{[2]} in the figure) is represented by a square plot. In the illustrated example, the predicted sale prices sp_{[µ]} at adjacent sale periods (annual) are displayed while being connected by a straight line, but the predicted sale prices sp_{[µ]} may be displayed only by a plot.

The above display allows the user Uk to recognize the time when the secondary battery can be sold at a higher price than a sale timing desired by the user Uk.

The functions and effects of the configuration of the battery secondary use assistance device 20 according to the present embodiment described above will be described.

According to the present embodiment, the battery state data generation unit 22 sets a plurality of primary use end time candidates t_{1e[µ]} including the desired trading time t_{bs} based on the desired trading time t_{bs} of the user Uk acquired in advance. The user-provided data generation unit 23 generates user-provided data including the recommended sale time tᵣₑ and the maximum sale price sp_{[M]} associated therewith, and the desired trading time t_{bs} and the predicted sale price sp_{[ths]} associated therewith.

Accordingly, a specific logic is implemented for providing (notifying), to the user Uk, the time when the secondary battery can be sold at a higher price than the sale timing desired by the user Uk.

### [Fourth Embodiment]

Hereinafter, a fourth embodiment will be described. Note that the same elements as those in the first to third embodiments are denoted by the same reference numerals, and the description thereof will be omitted.

A secondary battery of the present embodiment is assumed to be configured as a battery pack including a plurality of modules. The market price DB 27 stores, as a battery market price, a pack market price when the secondary battery is sold in pack units and a module market price when the secondary battery is sold in module units.

The battery secondary use assistance device 20 of the present embodiment performs the following processing based on the processing described in the third embodiment.

Specifically, in S440 of FIG. 4A, the battery state data generation unit 22 calculates, as the predicted battery state quantity Aₖ, an average SOH (hereinafter, also referred to as "predicted average SOH"), a lower limit SOH (hereinafter, also referred to as "predicted lower limit SOH"), SOH uniformity (hereinafter, also referred to as "predicted SOH uniformity"), and an average internal resistance (hereinafter, also referred to as "predicted average internal resistance") of each of the modules at the secondary use start time t₂ₑ, and a SOH for each of the modules to be sold (hereinafter, also referred to as "predicted individual SOH").

The user-provided data generation unit 23 first calculates a basic predicted pack transaction price of the secondary battery at the secondary use start time t₂ₑ based on the predicted average SOH. A specific arithmetic logic of the basic predicted pack transaction price is the same as the arithmetic logic (S510 and S520 in FIG. 5) of the estimated transaction price vt_{[µ]} described in the third embodiment. However, in the present embodiment, in calculating the basic predicted pack transaction price in S520, the pack market price of the market price DB 27 is referenced.

Next, the user-provided data generation unit 23 compares the predicted average internal resistance with a predetermined determination value. When the predicted average internal resistance is larger than the determination value, the user-provided data generation unit 23 stores the basic predicted pack transaction price in a predetermined storage area as a predicted pack transaction price. On the other hand, when the predicted average internal resistance is equal to or less than the determination value, the user-provided data generation unit 23 stores a corrected predicted pack transaction price obtained by performing increase-correction on the basic predicted pack transaction price in the predetermined storage area as the predicted pack transaction price.

Next, the user-provided data generation unit 23 calculates a final estimated transaction price vt_{[µ]} from the predicted pack transaction price with reference to the predicted lower limit SOH and the predicted SOH uniformity.

Specifically, the user-provided data generation unit 23 compares the predicted lower limit SOH and the predicted SOH uniformity with the determination value determined separately. When both the predicted lower limit SOH and the predicted SOH uniformity are equal to or larger than the determination value determined separately, the user-provided data generation unit 23 directly calculates the predicted pack transaction price as the final estimated transaction price vt_{[µ]}.

On the other hand, when at least one of the predicted lower limit SOH and the predicted SOH uniformity is smaller than the determination value, the user-provided data generation unit 23 calculates the predicted module transaction price obtained by performing reduction-correction on the predicted pack transaction price as the estimated transaction price vt_{[µ]}. In particular, the user-provided data generation unit 23 refers to the market price DB 27, extracts a module market price of a module having a predicted individual SOH equal to or larger than a certain value, and sets the module market price as the predicted module transaction price.

As in the second embodiment, the user-provided data generation unit 23 calculates the predicted sale price sp_{[µ]} of the secondary battery from the estimated transaction price vt_{[µ]} and the transportation cost tc_{[µ]} associated therewith (S540). Therefore, according to the present embodiment, a specific logic is implemented for determining the predicted sale price sp_{[µ]} to be provided to the user Uk, appropriately considering whether the sale in pack units or the sale in module units is applied.

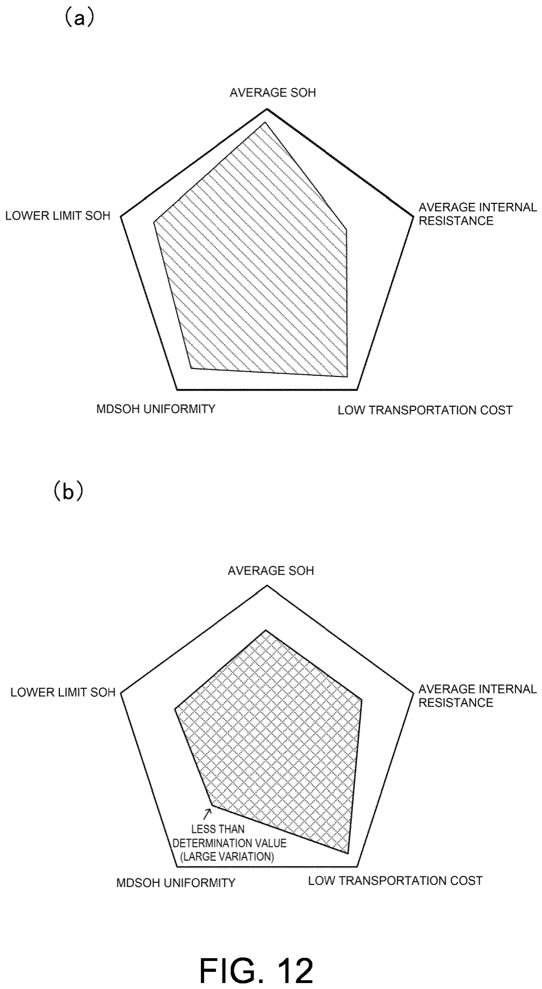

FIG. 12 illustrates an example of a calculation image of a specific predicted sale price sp_{[µ]} in the present embodiment. In particular, (a) of FIG. 12 illustrates the battery state quantities and the transportation cost tc_{[3]} at a predetermined first sale time candidate (for example, primary use end time candidate t_{1e[3]}). Further, (b) of FIG. 12 illustrates battery state quantities and a transportation cost tc_{[6]} at a second sale time candidate (for example, primary use end time candidate t_{1e[6]}) after a predetermined period of time has elapsed from the first sale time candidate t_{1e[3]}.

In the first sale time candidate t_{1e[3]} illustrated in (a) of Fig. 12, the predicted lower limit SOH and the predicted SOH uniformity are both equal to or larger than the determination value, and an estimated transaction price vt_{[3]} based on the pack market price is calculated. Further, the predicted average internal resistance increases by a certain amount or more. However, since the predicted average SOH is above the standard, the estimated transaction price vt_{[3]} is calculated from the pack market price based on the corresponding secondary use destination Su (for example, for stationary use rather than EV reuse). Since the transportation cost tc_{[3]} is also below the standard, a final predicted sale price sp_{[3]} is determined from the estimated transaction price vt_{[3]}.

Further, in the second sale time candidate t_{1e[6]} illustrated in (b) of FIG. 12, the degradation of the secondary battery progresses, and at least the SOH uniformity is lower than the determination value. Therefore, the estimated transaction price vt_{[6]} is calculated on the premise of the sale in module units. Since a transportation cost tc_{[7]} is also below the standard, a final predicted sale price sp_{[6]} is determined from the estimated transaction price vt_{[6]}.

Further, according to the present embodiment, in the user terminal UTk, it is possible to display the predicted sale prices sp_{[µ]} at the recommended sale time tᵣₑ, the desired trading time t_{bs}, and other sale time candidates (primary use end time candidates t_{1e[µ]}) by reflecting fluctuations across a switching timing between a sale price in pack units and a sale price in module units.

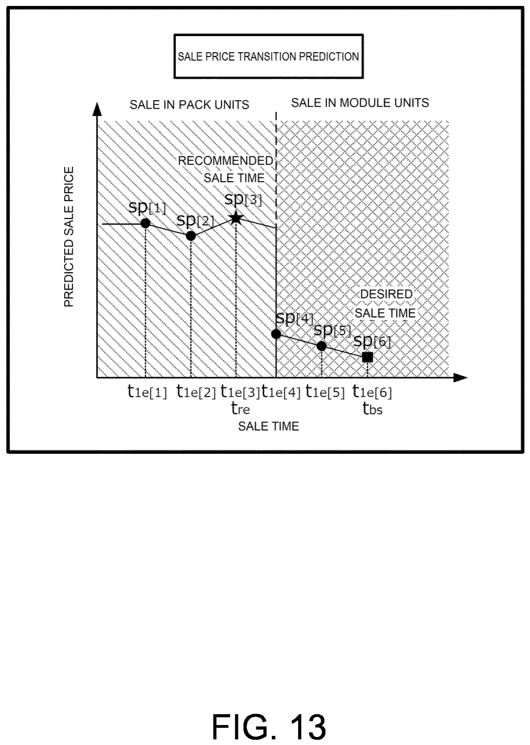

FIG. 13 illustrates an example of a display mode of the user-provided data according to the present embodiment. In the illustrated example, it is assumed that the predicted lower limit SOH and the predicted SOH uniformity are equal to or less than the determination value at a predetermined price switching timing (primary use end time candidate t_{1e[4]} in the figure) as the degradation of the secondary battery progresses. Therefore, in the primary use end time candidate t_{1e[4]}, the predicted sale price sp_{[µ]} is switched from a calculated value on the premise of the sale in pack units to a calculated value on the premise of the sale in module units.

Further, the predicted sale price sp_{[µ]} is calculated with a value on the premise of the sale in module units after the primary use end time candidate t_{1e[4]}. Therefore, it is possible to display the predicted sale prices sp reflecting the fluctuations across the switching timing between the sale price in pack units and the sale price in module units. Therefore, it is possible to provide (notify), to the user Uk, the degradation progression of the secondary battery corresponding to the usage mode of the user Uk, fluctuations in market prices including the sale in pack units and the sale in module units, and transition information on the predicted sale price sp in a predetermined period including the desired sale time t_{bs} and the recommended sale time tᵣₑ.

In the display example of FIG. 13, the recommended sale time tᵣₑ is determined to be a timing (primary use end time candidate t_{1e[3]} in the figure) when a highest price is taken before the primary use end time candidate t_{1e[4]}. Further, the desired trading time t_{bs} of the user Uk is displayed as a timing after the primary use end time candidate t_{1e[4]} (t_{1e[6]} in the figure), and the predicted sale price sp_{[6]} at the desired trading time t_{bs} is displayed at a relatively low price on the premise of the sale in module units. Therefore, according to the display of FIG. 13, it is possible to clearly indicate, to the user Uk, the recommended sale time tᵣₑ that is the time when the sale in pack units can be performed earlier than the desired trading time t_{bs} of the user Uk and the secondary battery can be sold at a particularly high price. Accordingly, it is possible to prompt the user Uk to sell the secondary battery (provide the secondary battery to the secondary use destination Su) as quickly as possible. As a result, it is possible to promote the provision of the secondary battery to the secondary use destination Su at the time when the sale in pack units is possible, and to reduce a quantity of waste in module units.

With the above display mode, even when the sale time of the secondary battery reaches the time when the sale in pack units cannot be performed due to individual circumstances of the user Uk or the like, the transition of the predicted sale price sp on the premise of the sale in module units is displayed. Therefore, it is possible to prompt the user Uk to sell the secondary battery as quickly as possible even during a period when only the sale in module units is possible, and thus it is possible to reduce a total quantity of battery waste, including the quantity of waste in module units.

Although the embodiments of the present invention have been described above, the configurations described in the above-mentioned embodiments are merely examples of applications of the present invention, and are not intended to limit the technical scope of the present invention.

For example, in the above embodiments, the example has been described in which the predicted degradation profile P_{Uk}(t) is calculated based on the degradation profile during primary use P_{TO1k}(t) indicating the degradation transition of the secondary battery during primary use and the degradation profile during storage P_{S2k}(t) indicating the degradation transition of the secondary battery during the storage period [t₁ₑ, t₂ₑ]. Further, when the influence of degradation during the storage period [t₁ₑ, t₂ₑ] is small, such as when the period from the primary use end time t₁ₑ to the secondary use start time t₂ₑ is short, a configuration may be adopted in which the degradation profile during primary use P_{TO1k}(t) is directly used as the predicted degradation profile P_{Uk}(t) to simplify the arithmetic logic. In this case, a value of the predicted degradation profile P_{Uk}(t) at the primary use end time t₁ₑ, instead of the secondary use start time t₂ₑ, can be acquired as the predicted battery state quantity Aₖ.

In the above embodiments, the example has been described in which the battery secondary use assistance device 20 outputs the generated user-provided data to the user terminal UTk. However, a configuration in which the battery secondary use assistance device 20 outputs the user-provided data to the in-vehicle terminal VTk or a configuration in which the battery secondary use assistance device 20 outputs the user-provided data to both the user terminal UTk and the in-vehicle terminal VTk may be adopted. Further, a configuration in which the processing in the battery secondary use assistance device 20 described in the embodiments is executed by the user terminal UTk or the in-vehicle terminal VTk, or a configuration in which the processing is executed by being distributed to at least two of the battery secondary use assistance device 20, the user terminal UTk, and the in-vehicle terminal VTk may be adopted.

More specifically, the scope of disclosure at the time of the filing of the present application includes a user terminal device (user terminal UTk) that assists the user Uk of the vehicle Vk equipped with a secondary battery in providing the secondary battery for secondary use. In particular, the user terminal UTk includes a degradation history data generation unit that generates degradation history data indicating degradation progression of the secondary battery from the predetermined reference time t₀ to the current time based on use tendency information on the vehicle Vk or the secondary battery, the battery state data generation unit 22 that calculates the predicted battery state quantity Aₖ indicating a state of the secondary battery at the predetermined primary use end time t₁ₑ or the predetermined secondary use start time t₂ₑ based on the degradation history data and generates predicted battery state data including the predicted battery state quantity, the user-provided data generation unit 23 that generates user-provided data based on the predicted battery state data, and a user-provided data display unit (a display processor, a display, or the like) that performs predetermined display with reference to the user-provided data.

The scope of disclosure at the time of the filing of the present application includes an in-vehicle terminal device (in-vehicle terminal VTk) that is to be mounted on the vehicle Vk equipped with a secondary battery and assists the user Uk of the vehicle Vk in providing the secondary battery for secondary use. In particular, the in-vehicle terminal VTk includes a degradation history data generation unit that generates degradation history data indicating degradation progression of the secondary battery from the predetermined reference time to to the current time based on use tendency information on the vehicle Vk or the secondary battery, the battery state data generation unit 22 that calculates the predicted battery state quantity Aₖ indicating a state of the secondary battery at the predetermined primary use end time t₁ₑ or the predetermined secondary use start time t₂ₑ based on the degradation history data and generates predicted battery state data including the predicted battery state quantity Aₖ, the user-provided data generation unit 23 that generates user-provided data based on the predicted battery state data, and a user-provided data display unit (a display processor, an in-vehicle display, or the like) that performs predetermined display with reference to the user-provided data.

Further, the scope of disclosure at the time of the filing of the present application includes the battery secondary use assistance system 10 that assists the users U (U1, U2, ..., Un) of the vehicles V (V1, V2, ..., Vn) each equipped with a secondary battery in providing the secondary battery for secondary use. In particular, the battery secondary use assistance system 10 includes the battery secondary use assistance device 20, the user terminal UT, and the in-vehicle terminal VT, which are communicably connected to each other via the predetermined network 100, and a processing device including any one or two or more of the battery secondary use assistance device 20, the user terminal UT, and the in-vehicle terminal VT.

The processing device includes a degradation history data generation unit that generates degradation history data indicating degradation progression of the secondary battery from the predetermined reference time t₀ to the current time based on use tendency information on the vehicle Vk or the secondary battery, the battery state data generation unit 22 that calculates the predicted battery state quantity Aₖ indicating a state of the secondary battery at the predetermined primary use end time t₁ₑ or the predetermined secondary use start time t₂ₑ based on the degradation history data and generates predicted battery state data including the predicted battery state quantity Aₖ, the user-provided data generation unit 23 that generates user-provided data based on the predicted battery state data, and a user-provided data display unit that performs predetermined display on a display unit of the user terminal UT and/or the in-vehicle terminal VT with reference to the user-provided data.

The scope of disclosure at the time of the filing of the present application includes a battery secondary use assistance method for assisting the user Uk of the vehicle Vk equipped with a secondary battery in providing the secondary battery for secondary use. The battery secondary use assistance method includes a degradation history data generation step of generating degradation history data indicating degradation progression of the secondary battery from the predetermined reference time t₀ to the current time based on use tendency information on the vehicle Vk or the secondary battery, a battery state data generation step of calculating the predicted battery state quantity Aₖ indicating a state of the secondary battery at the predetermined primary use end time t₁ₑ or the predetermined secondary use start time t₂ₑ based on the degradation history data and generating predicted battery state data including the predicted battery state quantity Aₖ, a user-provided data generation step of generating user-provided data based on the predicted battery state data, and a data output step of outputting the user-provided data to the user terminal UTk to be operated by the user Uk and/or the in-vehicle terminal VTk mounted on the vehicle Vk.

The scope of disclosure at the time of the filing of the present application includes a battery secondary use assistance program for assisting the user Uk of the vehicle Vk equipped with a secondary battery in providing the secondary battery for secondary use, and a computer-readable storage medium that stores the battery secondary use assistance program.

In particular, the battery secondary use assistance program causes a computer to (i) generate degradation history data indicating degradation progression of the secondary battery from the predetermined reference time to to the current time based on use tendency information on the vehicle Vk or the secondary battery, (ii) calculate the predicted battery state quantity Aₖ indicating a state of the secondary battery at the predetermined primary use end time t₁ₑ or the predetermined secondary use start time t₂ₑ based on the degradation history data and generate predicted battery state data including the predicted battery state quantity Aₖ, (iii) generate user-provided data based on the predicted battery state data, and (iv) perform predetermined display on a display unit of the user terminal UT and/or the in-vehicle terminal VT with reference to the user-provided data.

## Claims

1. A battery secondary use assistance device that assists a user of a vehicle equipped with a secondary battery in providing the secondary battery for secondary use, the battery secondary use assistance device comprising:
a degradation history data generation unit configured to generate degradation history data indicating degradation progression of the secondary battery from a predetermined reference time to a current time based on use tendency information on the vehicle or the secondary battery;
a battery state data generation unit configured to calculate a predicted battery state quantity indicating a state of the secondary battery at a predetermined primary use end time or a predetermined secondary use start time based on the degradation history data and generate predicted battery state data including the predicted battery state quantity;
a user-provided data generation unit configured to generate user-provided data based on the predicted battery state data; and
a data output unit configured to output the user-provided data to a user terminal to be operated by the user and/or an in-vehicle terminal mounted on the vehicle.

2. The battery secondary use assistance device according to claim 1, wherein
the degradation history data generation unit
generates cycle degradation history data indicating a transition of cycle degradation of the secondary battery from the reference time to the current time with reference to a travel frequency of the vehicle contained in the use tendency information, and
generates storage degradation history data indicating a transition of storage degradation of the secondary battery from the reference time to the current time with reference to a stopping frequency of the vehicle contained in the use tendency information, and
the battery state data generation unit
calculates a cycle degradation profile indicating a transition of cycle degradation from the reference time to the primary use end time based on the cycle degradation history data,
calculates a storage degradation profile indicating a transition of storage degradation from the reference time to the primary use end time based on the storage degradation history data,
calculates a degradation profile during primary use that indicates a total degradation transition of the secondary battery from the reference time to the primary use end time based on the cycle degradation profile and the storage degradation profile, and
calculates the predicted battery state quantity based on the degradation profile during primary use.

3. The battery secondary use assistance device according to claim 2, wherein
the battery state data generation unit
calculates a degradation profile during storage that indicates a transition of storage degradation of the secondary battery in a storage period from the primary use end time to the secondary use start time, and
calculates the predicted battery state quantity based on the degradation profile during primary use and the degradation profile during storage.

4. The battery secondary use assistance device according to claim 3, wherein
the battery state data generation unit
determines the primary use end time and the secondary use start time based on a desired trading time of the user acquired in advance.

5. The battery secondary use assistance device according to claim 3, wherein
the battery state data generation unit
calculates the predicted battery state quantity for each of secondary use start time candidates respectively corresponding to a plurality of predetermined primary use end time candidates.

6. The battery secondary use assistance device according to claim 1, wherein
the user-provided data generation unit
calculates a predicted sale price of the secondary battery at the secondary use start time based on the predicted battery state data, and
generates the user-provided data including at least the predicted sale price.

7. The battery secondary use assistance device according to claim 6, further comprising:
a secondary use destination database configured to store information on a secondary use destination; and
a market price database configured to store a general battery transaction price corresponding to a battery state and a sale time, wherein
the user-provided data generation unit
extracts a plurality of secondary use destination candidates based on the predicted battery state data with reference to the secondary use destination database,
calculates an estimated transaction price of the secondary battery based on the predicted battery state data according to each of the extracted secondary use destination candidates with reference to the market price database, and
calculates the predicted sale price based on the estimated transaction price.

8. The battery secondary use assistance device according to claim 6, further comprising:
a secondary use destination database configured to store information on a secondary use destination; and
a market price database configured to store a general battery transaction price corresponding to a battery state and a sale time, wherein
the battery state data generation unit
calculates the predicted battery state quantities respectively corresponding to a plurality of predetermined primary use end time candidates, and
generates the predicted battery state data including combinations of the predicted battery state quantities and the respective primary use end time candidates, and
the user-provided data generation unit
extracts a plurality of secondary use destination candidates based on the predicted battery state data with reference to the secondary use destination database,
calculates estimated transaction prices of the secondary battery for the combinations of the predicted battery state quantities and the respective secondary use destination candidates with reference to the market price database,
calculates the predicted sale prices respectively corresponding to the estimated transaction prices,
sets, as a recommended sale time, one of the primary use end time candidates associated with a maximum sale price among the predicted sale prices, and
generates the user-provided data including the recommended sale time.

9. The battery secondary use assistance device according to claim 8, wherein
the battery state data generation unit
sets, based on a desired trading time of the user acquired in advance, the plurality of primary use end time candidates including the desired trading time, and
the user-provided data generation unit
generates the user-provided data including the recommended sale time and the maximum sale price associated therewith, and the desired trading time and the predicted sale price associated therewith.

10. The battery secondary use assistance device according to any one of claims 7 to 9, wherein
the user-provided data generation unit
estimates a primary use location of the secondary battery based on position information of the vehicle,
calculates a transportation cost of the secondary battery from the primary use location to each of the secondary use destination candidates, and
determines the predicted sale price from a value obtained by subtracting the transportation cost from a corresponding one of the estimated transaction prices.

11. The battery secondary use assistance device according to claim 6, wherein
the secondary battery is configured as a battery pack including a plurality of modules,
the battery state data generation unit
calculates, as the predicted battery state quantity, an average SOH and a lower limit SOH of each of the modules at the primary use end time or the secondary use start time, and
the user-provided data generation unit
calculates a predicted pack transaction price of the secondary battery at the primary use end time or the secondary use start time based on the average SOH,
calculates the predicted sale price based on the predicted pack transaction price when the lower limit SOH is equal to or larger than a predetermined determination value, and
calculates, as the predicted sale price, a predicted module transaction price obtained by performing reduction-correction on the predicted pack transaction price when the lower limit SOH is smaller than the determination value.

12. The battery secondary use assistance device according to claim 6, wherein
the secondary battery is configured as a battery pack including a plurality of modules,
the battery state data generation unit
calculates, as the predicted battery state quantity, an average SOH and SOH uniformity of each of the modules at the primary use end time or the secondary use start time, and
the user-provided data generation unit
calculates a predicted pack transaction price of the secondary battery at the primary use end time or the secondary use start time based on the average SOH,
calculates the predicted sale price based on the predicted pack transaction price when the SOH uniformity is equal to or larger than a predetermined determination value, and
calculates, as the predicted sale price, a predicted module transaction price obtained by performing reduction-correction on the predicted pack transaction price when the SOH uniformity is smaller than the determination value.

13. The battery secondary use assistance device according to claim 6, wherein
the secondary battery is configured as a battery pack including a plurality of modules,
the battery state data generation unit
calculates, as the predicted battery state quantity, an average SOH and an average internal resistance of each of the modules at the primary use end time or the secondary use start time, and
the user-provided data generation unit
calculates a basic predicted pack transaction price of the secondary battery at the primary use end time or the secondary use start time based on the average SOH,
calculates the predicted sale price based on the basic predicted pack transaction price when the average internal resistance is larger than a predetermined determination value, and
calculates the predicted sale price based on a corrected predicted pack transaction price obtained by performing increase-correction on the basic predicted pack transaction price when the average internal resistance is equal to or smaller than the determination value.

14. A user terminal device that assists a user of a vehicle equipped with a secondary battery in providing the secondary battery for secondary use, the user terminal device comprising:
a degradation history data generation unit configured to generate degradation history data indicating degradation progression of the secondary battery from a predetermined reference time to a current time based on use tendency information on the vehicle or the secondary battery;
a battery state data generation unit configured to calculate a predicted battery state quantity indicating a state of the secondary battery at a predetermined primary use end time or a predetermined secondary use start time based on the degradation history data and generate predicted battery state data including the predicted battery state quantity;
a user-provided data generation unit configured to generate user-provided data based on the predicted battery state data; and
a user-provided data display unit configured to perform predetermined display with reference to the user-provided data.

15. An in-vehicle terminal device that is to be mounted on a vehicle equipped with a secondary battery and assists a user of the vehicle in providing the secondary battery for secondary use, the in-vehicle terminal device comprising:
a degradation history data generation unit configured to generate degradation history data indicating degradation progression of the secondary battery from a predetermined reference time to a current time based on use tendency information on the vehicle or the secondary battery;
a battery state data generation unit configured to calculate a predicted battery state quantity indicating a state of the secondary battery at a predetermined primary use end time or a predetermined secondary use start time based on the degradation history data and generate predicted battery state data including the predicted battery state quantity;
a user-provided data generation unit configured to generate user-provided data based on the predicted battery state data; and
a user-provided data display unit configured to perform predetermined display with reference to the user-provided data.

16. A battery secondary use assistance system that assists a user of a vehicle equipped with a secondary battery in providing the secondary battery for secondary use, the battery secondary use assistance system comprising:
a battery secondary use assistance device, a user terminal, and an in-vehicle terminal that are communicably connected to each other via a predetermined network; and
a processing device including any one or two or more of the battery secondary use assistance device, the user terminal, and the in-vehicle terminal, wherein
the processing device includes
a degradation history data generation unit configured to generate degradation history data indicating degradation progression of the secondary battery from a predetermined reference time to a current time based on use tendency information on the vehicle or the secondary battery,
a battery state data generation unit configured to calculate a predicted battery state quantity indicating a state of the secondary battery at a predetermined primary use end time or a predetermined secondary use start time based on the degradation history data and generate predicted battery state data including the predicted battery state quantity,
a user-provided data generation unit configured to generate user-provided data based on the predicted battery state data, and
a user-provided data display unit configured to perform predetermined display on a display unit of the user terminal and/or the in-vehicle terminal with reference to the user-provided data.

17. A battery secondary use assistance method for assisting a user of a vehicle equipped with a secondary battery in providing the secondary battery for secondary use, the battery secondary use assistance method comprising:
a degradation history data generation step of generating degradation history data indicating degradation progression of the secondary battery from a predetermined reference time to a current time based on use tendency information on the vehicle or the secondary battery;
a battery state data generation step of calculating a predicted battery state quantity indicating a state of the secondary battery at a predetermined primary use end time or a predetermined secondary use start time based on the degradation history data and generating predicted battery state data including the predicted battery state quantity;
a user-provided data generation step of generating user-provided data based on the predicted battery state data; and
a data output unit step of outputting the user-provided data to a user terminal to be operated by the user and/or an in-vehicle terminal mounted on the vehicle.
